(19) Europäisches Patentamt / European Patent Office / Office européen des brevets

(11) **EP 1 668 378 B1**

(12) **EUROPÄISCHE PATENTSCHRIFT**

(45) Veröffentlichungstag und Bekanntmachung des Hinweises auf die Patenterteilung:
**09.09.2015 Patentblatt 2015/37**

(21) Anmeldenummer: **03769295.1**

(22) Anmeldetag: **22.08.2003**

(51) Int Cl.:
***G01R 33/02*** *(2006.01)*

(86) Internationale Anmeldenummer:
**PCT/EP2003/010503**

(87) Internationale Veröffentlichungsnummer:
**WO 2005/029106 (31.03.2005 Gazette 2005/13)**

(54) **SENSOR FÜR DIE DETEKTION DER RICHTUNG EINES MAGNETFELDES IN EINER EBENE**

SENSOR FOR DETECTING THE DIRECTION OF A MAGNETIC FIELD IN A PLANE

DETECTEUR POUR CAPTER L'ORIENTATION D'UN CHAMP MAGNETIQUE DANS UN PLAN

(84) Benannte Vertragsstaaten:
**AT BE BG CH CY CZ DE DK EE ES FI FR GB GR HU IE IT LI LU MC NL PT RO SE SI SK TR**

(43) Veröffentlichungstag der Anmeldung:
**14.06.2006 Patentblatt 2006/24**

(73) Patentinhaber: **Melexis Technologies NV**
**3980 Tessenderlo (BE)**

(72) Erfinder:
• **POPOVIC, Radivoje**
**CH-1025 St-Sulpice (CH)**
• **SCHOTT, Christian**
**CH-1110 Morges (CH)**

(74) Vertreter: **Falk, Urs**
**Patentanwaltsbüro Dr. Urs Falk**
**Eichholzweg 9A**
**6312 Steinhausen (CH)**

(56) Entgegenhaltungen:
**EP-A- 1 182 461    WO-A-01/18556**
**US-A- 4 599 564**

• **POPOVIC R S: "Not-plate-like Hall magnetic sensors and their applications" SENSORS AND ACTUATORS A, ELSEVIER SEQUOIA S.A., LAUSANNE, CH, Bd. 85, Nr. 1-3, 25. August 2000 (2000-08-25), Seiten 9-17, XP004214441 ISSN: 0924-4247**

**Beschreibung**

Die Erfindung betrifft einen Sensor der im Oberbegriff des Anspruchs 1 genannten Art.

Solche Sensoren eignen sich beispielsweise zur Messung der Richtung eines Magnetfeldes in einer Ebene. Heutzutage werden fast ausschliesslich Sensoren eingesetzt, die die Komponenten des. Magnetfeldes bezüglich zweier orthogonale Koordinatenachsen messen. Diese Sensoren enthalten Magnetfeldsensoren wie beispielsweise magnetoresistive Bauelemente (z. B. Philips KMZ41) oder Hallelemente (z. B. Sentron 2SA-10). Die Magnetfeldsensoren liefern zwei analoge Ausgangsspannungen, die proportional zur Sinus- bzw. Cosinusfunktion der Richtung des Magnetfeldes sind. Die Richtung des Magnetfeldes kann aus diesen beiden Ausgangsspannungen bestimmt werden. Dazu müssen einerseits aus den Vorzeichen der beiden Ausgangsspannungen der Quadrant der Feldrichtung bestimmt und andererseits der Arcustangens des Quotienten der beiden Ausgangsspannungen berechnet werden. Da eine genaue analoge Quotientenbildung sehr aufwendig zu implementieren ist, erfolgt die Quotientenbildung oftmals auf digitale Weise, beispielsweise mittels des iterativen CORDIC Algorithmus. Die digitale Quotientenbildung ist zeitaufwendig und damit langsam. Zudem muss der Sensor für die Durchführung dieser Berechnungen einen Microkontroller aufweisen. Ein solcher Sensor ist daher gross, teuer und langsam.

Ein solcher Sensor wird beispielsweise in einem Winkelgeber eingesetzt, um die Richtung eines von einem Permanentmagneten erzeugten Magnetfeldes zu messen. Hier besteht ein weiteres Problem darin, dass die Stärke des vom Permanentmagneten erzeugten Magnetfeldes stark von der Temperatur des Permanentmagneten abhängig ist. Dies erfordert einen grossen Messbereich des Sensors. Bei Sensoren, die einen ferromagnetischen Kern für die passive Verstärkung des Magnetfeldes aufweisen, besteht die Gefahr, dass das Magnetfeld den ferromagnetischen Kern sättigt oder mindestens teilweise sättigt, was zu Messfehlern führt.

Ein Sensor der im Oberbegriff des Anspruchs 1 genannten Art ist aus der EP 1182461 bekannt. Der Sensor eignet sich für die Bestimmung der Richtung eines zweidimensionalen Magnetfeldes. Der Sensor umfasst einen Magnetfeldkonzentrator mit einer flächigen Form und zwei Magnetfeldsensoren, die mindestens ein Hallelement umfassen, wobei die Hallelemente im Bereich des Randes des Magnetfeldkonzentrators angeordnet sind. Der erste Magnetfeldsensor misst eine erste Komponente des Magnetfeldes und der zweite Magnetfeldsensor misst eine zweite Komponente des Magnetfeldes. Aus den Signalen der beiden Magnetfeldsensoren lässt sich somit die Richtung des Magnetfeldes bestimmen.

Der Erfindung liegt die Aufgabe zugrunde, einen Sensor zu entwickeln, bei dem es sich die Richtung des externen Magnetfeldes in einer Ebene auf einfache Weise bestimmen lässt.

Die genannte Aufgabe wird erfindungsgemäss gelöst durch die Merkmale des Vorrichtungsanspruchs 1 und des entsprechendes Verfahrensanspruchs 8.

Ein erfindungsgemässer Sensor umfasst einen Halbleiterchip mit mindestens drei Magnetfeldsensoren, Logik-, Verstärker- und Auswerteschaltungen. Die Amplituden der Ausgangssignale der Magnetfeldsensoren hängen von der Richtung des externen Magnetfeldes ab. Als Magnetfeldsensoren werden vorzugsweise in den Halbleiterchip integrierte Hallelemente verwendet, es können aber auch magnetoresistive oder andere magnetfeldempfindliche Sensoren verwendet werden. In einer bevorzugten Ausführungsform ist auf die Oberfläche des Halbleiterchips ein flacher ringförmiger oder scheibenförmiger Magnetfeldkonzentrator aus ferromagnetischem Material aufgebracht. Der Sensor dient zur Bestimmung der Richtung eines externen Magnetfeldes in der durch die Oberfläche des Halbleiterchips bzw. den flachen Magnetfeldkonzentrator definierten Ebene. Die Richtung des Magnetfeldes in dieser Ebene kann durch einen polaren Winkel $\varphi$ charakterisiert werden. Der Sensor ist charakterisiert durch eine Anzahl k von mindestens drei Messachsen, die sich in einem gemeinsamen Punkt schneiden. Die Messachsen sind durch je einen polaren Winkel definiert, wobei der Winkel $\psi$ der Messachse mit der Nummer m gegeben ist durch $\Psi_m = m \dfrac{180°}{k}$. Für einen Sensor mit k = 3 Messachsen ergeben sich die Winkel $\psi_0 = 0°$, $\psi_1 = 60°$, und $\psi_2 = 120°$. Für einen Sensor mit k = 4 Messachsen ergeben sich die Winkel $\psi_0 = 0°$, $\psi_1 = 45°$, $\psi_2 = 90°$ und $\psi_3 = 135°$. Jeder Messachse ist mindestens ein Magnetfeldsensor zugeordnet. Die Zuordnung eines Magnetfeldsensors zu einer Messachse ist so definiert, dass das Ausgangssignal des Magnetfeldsensors immer dann am grössten ist, wenn das externe Magnetfeld parallel zu seiner Messachse verläuft.

Die Messachsen unterteilen die Ebene in verschiedene, aneinander angrenzende Sektoren. Die Anzahl der Sektoren ist doppelt so gross wie die Anzahl der Messachsen. Die Richtung des zu messenden Magnetfeldes fällt immer in einen der Sektoren. Für die Messung wird aber nicht derjenige Sektor benutzt, in den das Magnetfeld fällt, sondern einer der beiden Sektoren, in den eine senkrecht zum Magnetfeld verlaufende Nulldurchgangslinie fällt. In diesem ausgewählten Sektor ist es möglich, trigonometrische Funktionen wie Sin(x) und Tan(x) bzw. ihre Umkehrfunktionen Arcsin(x) und Arctan(x) durch das Argument x zu ersetzen, ohne dass die Genauigkeit des Messresultats zu sehr vermindert wird, und somit den Winkel $\varphi$ mit den mathematischen Grundrechenarten Subtraktion, Addition, Division und Multiplikation aus den Ausgangssignalen derjenigen Magnetfeldsensoren zu berechnen, die auf den den ausgewählten Sektor begrenzenden Messachsen liegen. Der auszuwählende Sektor kann auf verschiedene Weise charakterisiert werden, zum einen sind die Ausgangssignale der Magnetfeldsensoren, die auf den ihn begrenzenden Messachsen liegen, betragsmässig kleiner als die Ausgangssignale der Magnetfeldsensoren, die auf den anderen Messachsen liegen. Zum anderen weisen die Ausgangssignale dieser ausgewählten Magnetfeldsensoren verschiedene Vorzeichen auf, sofern eine bestimmte Ordnung in der Anordnung und Beschaltung der Magnetfeldsensoren eingehalten wird.

Die von den Magnetfeldsensoren gelieferten Ausgangssignale liegen auf einer Sinuskurve, d.h. die Ausgangssignale der Magnetfeldsensoren sind proportional zum Sinus ihres Polarwinkels $\sin(\psi_m)$. Die ausgewählten Magnetfeldsensoren befinden sich beidseitig eines Nulldurchgangs der Sinuskurve. Im Bereich der Nulldurchgänge ist die Sinuskurve annähernd linear, so dass der Winkel $\varphi$ aus den Ausgangssignalen der beidseitig eines Nulldurchgangs liegenden Magnetfeldsensoren mit ausreichender Genauigkeit durch lineare Interpolation bestimmt werden kann.

Die Genauigkeit der Bestimmung des Winkels $\varphi$ kann noch erhöht werden, wenn der aus den Ausgangssignalen der Magnetfeldsensoren ermittelte Wert für den Winkel $\varphi$ mittels einer Kennlinie korrigiert wird. Die Kennlinie ist vorzugsweise in Form einer Tabelle vorhanden, wobei jedem aus den Ausgangssignalen ermittelten Wert der entsprechende korrekte Wert zugeordnet ist.

Es ist zweckmässig, pro Messachse paarweise zwei Magnetfeldsensoren vorzusehen. Deren Ausgangssignale sind betragsmässig gleich, unterscheiden sich aber im Vorzeichen. Weil sich deren Ausgangssignale nur im Vorzeichen unterscheiden, kann der eine der beiden Magnetfeldsensoren ein fiktiver sein, d.h. er ist physisch nicht vorhanden, aber sein Ausgangssignal wird aus dem Ausgangssignal des anderen Magnetfeldsensors abgeleitet. Diese Variante ermöglicht eine einfache Beschaltung und Auswertung, ohne dass eines oder beide Vorzeichen der Ausgangssignale der ermittelten benachbarten Magnetfeldsensoren bei der Auswertung umzukehren sind.

Der Sensor kann mit oder ohne Magnetfeldkonzentrator ausgebildet sein. Wenn der Sensor ohne Magnetfeldkonzentrator ausgebildet ist, dann müssen die Magnetfeldsensoren auf ein Magnetfeld empfindlich sein, das parallel zur Oberfläche des Halbleiterchips gerichtet ist. Die Magnetfeldsensoren, die zu verschiedenen Messachsen gehören, unterscheiden sich in ihrer Ausrichtung im Halbleiterchip. Ihre Lage auf dem Halbleiterchip spielt bei vielen Anwendungen keine Rolle. Wenn der Sensor mit einem flachen, ring- oder scheibenförmigen Magnetfeldkonzentrator versehen ist, dann sind die Magnetfeldsensoren entlang des Randes des Magnetfeldkonzentrators anzuordnen, wo die Feldstärke des Magnetfeldes am grössten ist.

Nachfolgend werden Ausführungsbeispiele der Erfindung anhand der Zeichnung näher erläutert.

Es zeigen:

Fig. 1    in Aufsicht einen ersten Sensor mit einem Magnetfeldkonzentrator und mit acht Magnetfeldsensoren,
Fig. 2    den Sensor im Querschnitt, und
Fig. 3    in Aufsicht einen zweiten Sensor ohne Magnetfeldkonzentrator und mit vier vertikalen Hallelementen.

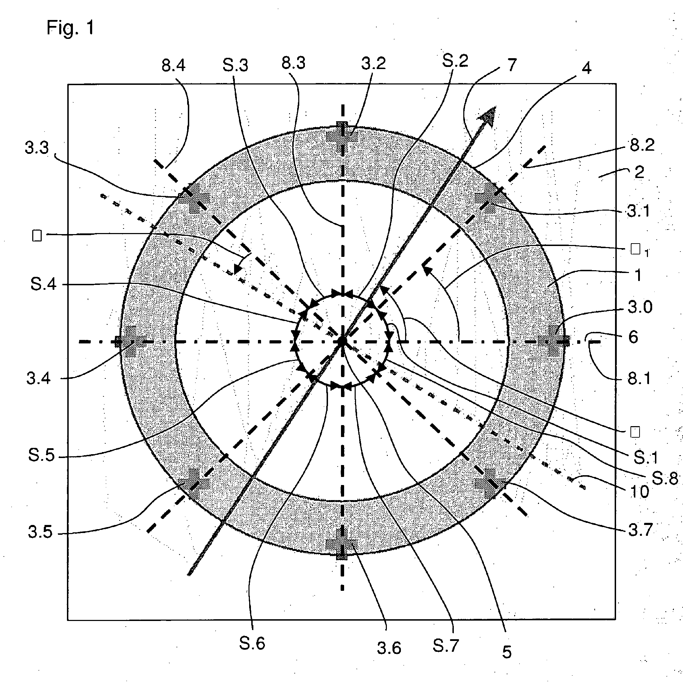

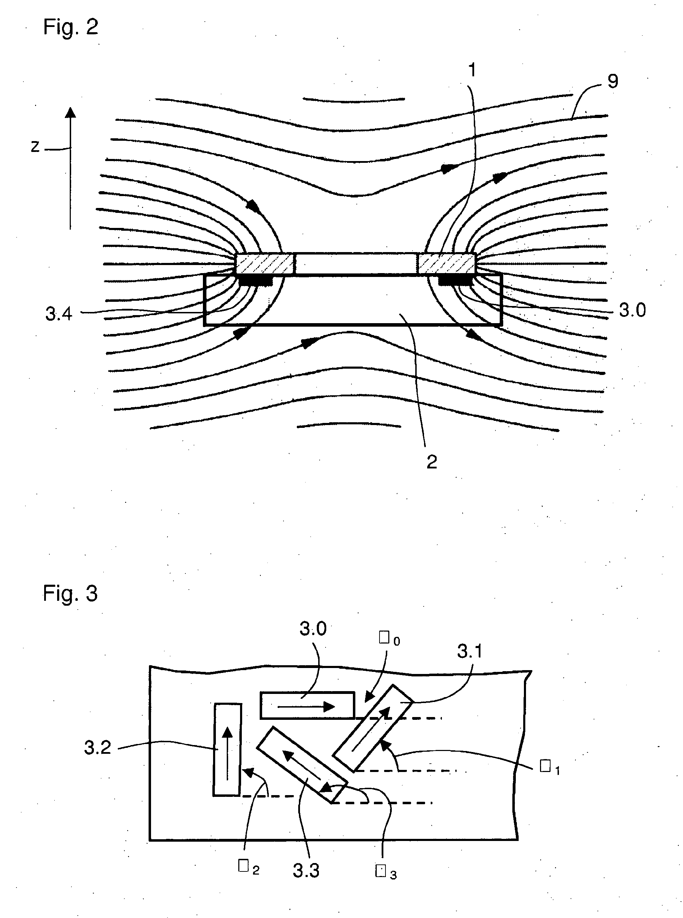

Die Fig. 1 zeigt in Aufsicht einen erfindungsgemässen Sensor in einer bevorzugten Ausführung mit einem Magnetfeldkonzentrator 1. Der Sensor besteht aus einem Halbleiter chip 2 mit dem auf seiner Oberseite angeordneten, flachen, ring- oder scheibenförmigen Magnetfeldkonzentrator 1 und einer Anzahl von n Magnetfeldsensoren 3.m, wobei der Index m die Werte von 0 bis n-1 annimmt, sowie Logik-, Verstärker- und Auswerteschaltungen. Die Anzahl n der Magnetfeldsensoren ist bevorzugt eine ganzzahlige Potenz der Zahl 2. Im Beispiel ist $n = 2^3 = 8$. Wenn der Magnetfeldkonzentrator 1 scheibenförmig ist, dann weist er vorzugsweise eine gleichmässige Dicke auf Er kann aber in der Mitte dicker als am Rand 4 ausgebildet sein. Der Magnetfeldkonzentrator 1 wirkt daher als Konzentrator für die beiden Komponenten des Magnetfeldes, die in der von ihm aufgespannten, als xy-Ebene bezeichneten Ebene liegen. Die Magnetfeldsensoren 3.0 bis 3.(n-1) sind in regelmässigem Winkelabstand entlang des Randes 4 des Magnetfeldkonzentrators 1 (entlang des äusseren Randes 4 bei einem ringförmigen Magnetfeldkonzentrator 1) angeordnet, da dort, wie der Fig. 2 zu entnehmen ist, die Feldstärke am grössten ist. Die Magnetfeldsensoren 3.1 bis 3.n sind der Reihe nach im Gegenuhrzeigersinn von 1 bis n nummeriert. Die Lage der Magnetfeldsensoren 3.0 bis 3.(n-1) wird vorzugsweise in Polarkoordinaten $(r, \psi)$ angegeben, wobei der Radius r für alle Magnetfeldsensoren 3.0 bis 3.(n-1) gleich ist und der dem Magnetfeldsensor 3.m zugeordnete Winkel $\psi_m$ gegeben ist durch $\psi_m = m*360°/n$. Die Richtung des externen Magnetfeldes in der vom Magnetfeldkonzentrator aufgespannten Ebene ist durch die Angabe eines polaren Winkels $\varphi$ vollständig definiert. Der Ursprung 5 des polaren Koordinatensystems und das Zentrum des ersten Magnetfeldsensors 3.0 definieren eine als Polarachse 6 bezeichnete Achse. Der Winkel $\varphi$ bezeichnet den Winkel, den das Magnetfeld und die Polarachse 6 einschliessen. In der Fig. 1 zeigt ein Pfeil 7 die Richtung des zu messenden Magnetfeldes in der durch den Magnetfeldkonzentrator 1 aufgespannten Ebene an. Der Pfeil 7 kann in eine beliebige Richtung zeigen, im Beispiel schliesst der Pfeil 7 mit der Polarachse 6 einen Winkel von etwa 60° ein. Als Material für den ferromagnetischen Magnetfeldkonzentrator wird vorzugsweise ein weichmagnetischer Werkstoff wie z.B. Vitrovac 6025Z gewählt. Das vom Magnetfeldsensor 3.m im Messbetrieb gelieferte Ausgangssignal wird mit Um bezeichnet.

Die n Magnetfeldsensoren definieren eine Anzahl von $k = n/2$ Messachsen 8.1 bis 8.4, d.h. bei diesem Beispiel sind jeder Messachse zwei Magnetfeldsensoren zugeordnet. Die Messachsen 8.1 bis 8.4 schneiden sich im Ursprung 5 des polaren Koordinatensystems. Die Messachsen 8.1 bis 8.4 begrenzen n Sektoren S.1 bis S.n, die von 1 bis n nummeriert sind. Jedem Sektor sind zwei Magnetfeldsensoren zugeordnet, die auf benachbarten Messachsen liegen. Dem Sektor S.m sind die Magnetfeldsensoren 3.(m-1) und 3.m zugeordnet. Die Polarachse 6 und die Messachse 8.1 fallen zusammen.

Die Fig. 2 zeigt den Verlauf der Feldlinien 9 des externen Magnetfeldes. Die orthogonal zur xy-Ebene verlaufende Raumrichtung wird als z-Richtung bezeichnet. Die Feldlinien am Ort der beiden Magnetfeldsensoren 3.0 und 3.4 zeigen in unterschiedliche z-Richtung, da das Magnetfeld am Ort des einen Magnetfeldsensors, hier des Magnetfeldsensors 3.4, in den Magnetfeldkonzentrator 1 eintritt und am Ort des anderen, gegenüberliegenden Magnetfeldsensors 3.0 diesen wieder verlässt. Die relative Penneabilität des Materials des Magnetfeldkonzentrators 1 ist grösser als 1000, während die relative Permeabilität von Luft und vom Halbleiterchip 2 etwa 1 beträgt. Die Feldlinien sind daher praktisch immer senkrecht zur Oberfläche des Magnetfeldkonzentrators 1 gerichtet. Als Magnetfeldsensoren werden vorzugsweise in den Halbleiterchip 2 integrierte Hallelemente verwendet, es können aber auch magnetoresistive oder andere magnetfeldempfindliche Sensoren verwendet werden. Im Beispiel der Fig. 1 sind die Magnetfeldsensoren sogenannte horizontale Halleelemente. Wenn die Magnetfeldsensoren empfindlich sind auf ein Magnetfeld, das orthogonal zur Oberfläche des Halbleiterchips 2 verläuft, wie beispielsweise die horizontalen Hallelemente, dann sind die Magnetfeldsensoren unterhalb des Randes 4 des Magnetfeldkonzentrators 1 anzuordnen. Wenn die Magnetfeldsensoren empfindlich sind auf ein Magnetfeld, das parallel zur Oberfläche des Halbleiterchips 2 verläuft, wie beispielsweise sogenannte vertikale Hallelemente, dann sind die Magnetfeldsensoren ausserhalb des Randes 4 und in tangentialer Ausrichtung zum Rand 4 des Magnetfeldkonzentrators 1 anzuordnen.

Weitere Angaben über den Aufbau eines solchen Sensors können der europäischen Patentanmeldung EP 1182461 entnommen werden. Die internationale Patentanmeldung PCT/EP03/50342 beschreibt ein Verfahren für den optimalen Betrieb eines solchen Sensors, bei dem der Magnetfeldkonzentrator mittels einer zusätzlichen Spule mit einer vorbestimmten Magnetisierung magnetisiert wird.

Für die folgenden Ausführungen wird wieder auf die Fig. 1 verwiesen. Eine den Ursprung 5 des polaren Koordinatensystems schneidende und senkrecht zur Magnetfeldrichtung verlaufende Linie wird als Nulldurchgangslinie 10 bezeichnet. Die Nulldurchgangslinie 10 trennt diejenigen Magnetfeldsensoren, welche ein positives Ausgangssignal führen, von denjenigen Magnetfeldsensoren, welche ein negatives Ausgangssignal führen.

Im Beispiel beträgt der Winkel $\varphi$ zwischen der Polarachse 6 und dem externen Magnetfeld etwa 60°. Dies hat zur Folge, dass in diesem Beispiel die Magnetfeldsensoren 3.0 bis 3.3 ein positives Ausgangssignal führten, während die Magnetfeldsensoren 3.4 bis 3.7 ein negatives Ausgangssignal führen. Die Nulldurchgangslinie 10 verläuft also zwischen den Magnetfeldsensoren 3.3 und 3.4 bzw. auch 3.7 und 3.0.

Es wird nun beschrieben, wie die Richtung des externen Magnetfeldes, d.h. der Winkel $\varphi$, bestimmt wird. Für die Bestimmung des Winkels $\varphi$ werden erfindungsgemäss zunächst diejenigen beiden benachbarten Magnetfeldsensoren ermittelt, bei denen die Vorzeichen ihrer Ausgangssignale verschieden sind. Der Winkel $\varphi$ wird dann aus der Position dieser beiden Magnetfeldsensoren und ihren Ausgangssignalen berechnet. Die Logik-, Verstärker- und Ausschalteschaltungen dienen dazu, die Magnetfeldsensoren entsprechend dem erfindungsgemässen Verfahren zu betreiben und deren Ausgangssignale zu verstärken und auszuwerten, sowie für weitere Aufgaben wie z. B. die Magnetisierung des ringförmigen Magnetfeldkonzentrators 1 gemäss der Lehre der vorgängig zitierten internationalen Patentanmeldung PCT/EP03/50342. Das erfindungsgemässe Verfahren umfasst die folgenden Schritte:

a) Bestimmung der beiden benachbarten Magnetfeldsensoren, zwischen denen das Vorzeichen der Ausgangssignale von einem positiven Wert auf einen negativen Wert wechselt. Dies kann beispielsweise so erfolgen: Beginnend mit dem ersten Magnetfeldsensor 3.0 wird in aufsteigender Reihenfolge zunächst der erste Magnetfeldsensor bestimmt, dessen Ausgangssignal positiv ist. Die Nummer dieses Magnetfeldsensors wird mit dem Buchstaben k bezeichnet. Sein Ausgangssignal ist folglich $U_k$. Im Beispiel ist k=1. Anschliessend wird der erste Magnetfeldsensor bestimmt, dessen Ausgangssignal negativ ist. Die Nummer dieses Magnetfeldsensors wird mit dem Buchstaben p bezeichnet. Sein Ausgangssignal ist folglich $U_p$. Im Beispiel ist p=4. Der Wechsel des Vorzeichens des Ausgangssignals erfolgt also zwischen den beiden benachbarten Magnetfeldsensoren 3.(p-1) und 3.p, im Beispiel zwischen den beiden Magnetfeldsensoren 3.3 und 3.4. Der für die Messung zu verwendende Sektor ist somit bestimmt: Diese beiden Magnetfeldsensoren 3.(p-1) und 3.p gehören zum Sektor S.p. Die Ausgangssignale dieser beiden Magnetfeldsensoren 3.(p-1) und 3.p sind zudem betragsmässig kleiner als die Ausgangssignale der Magnetfeldsensoren, die auf anderen Messachsen liegen.

b) Bestimmung des Winkels $\theta$, den die Nulldurchgangslinie 10 und die durch den Magnetfeldsensor 3.(p-1) verlaufende Messachse einschliessen, aus den Ausgangsspannungen $U_{p-1}$ und $U_p$. Der Winkel $\theta$ ist gegeben durch die Gleichung

$$\Theta = \frac{360°}{n} \frac{\text{Arc} \sin(U_{p-1})}{\text{Arc} \sin(U_{p-1}) - \text{Arc} \sin(U_p)}. \tag{1}$$

Die Erfindung macht nun Gebrauch von der Tatsache, dass für kleine Werte von x in guter Näherung sin(x) = x und somit auch umgekehrt x = Arcsin(x) gilt. Die Gleichung (1) kann deshalb in guter Näherung approximiert werden durch die Gleichung

$$\Theta = \frac{360°}{n} \frac{U_{p-1}}{U_{p-1} - U_p} \tag{2}$$

Diese Gleichung (2) entspricht einer linearen Interpolation zwischen den Messwerten benachbarter, im Winkelabstand 360°/n angeordneter Magnetfeldsensoren.

Im Beispiel der Fig. 1 erhält man

$$\Theta = \frac{360°}{n} \frac{U_3}{U_3 - U_4} \tag{3}$$

Bei der Gleichung (1) müssen die gemessenen Ausgangssignale $U_{p-1}$ und $U_p$ normiert werden, da sie in jedem Fall kleiner als die Zahl 1 sein müssen, da sonst der Arcussinus nicht definiert ist. Bei der Gleichung (2) entfällt wegen der Verhältnisbildung die Notwendigkeit der Normierung. Die Berechnung der Arcussinusfunktionen in Gleichung (1) ist kompliziert und zeitaufwendig. Bei der Gleichung (2) genügen eine Subtraktion und eine Division der Ausgangssignale von zwei benachbarten Magnetfeldsensoren, um den Winkel θ zu berechnen.

Der maximale Fehler des auf diese Weise ermittelten Winkels φ hängt von der Anzahl n der Magnetfeldsensoren sowie der Näherungsformel ab, die für die Ermittlung des Winkels φ aus den

Ausgangsspannungen $U_{p-1}$ und Up verwendet wird. Der maximale Fehler ist bei Verwendung der Gleichung (2) kleiner als etwa 1.1° bei n = 6 Magnetfeldsensoren, kleiner als etwa 0.45° bei n = 8 Magnetfeldsensoren und kleiner als etwa 0.14° bei n = 12 Magnetfeldsensoren.

c) Berechnung des Winkels φ zu

$$\varphi = \Psi_{p-1-\frac{n}{4}} + \Theta = \left[(p-1) - \frac{n}{4}\right]\frac{360°}{n} + \Theta. \tag{4}$$

Im Beispiel der Fig. 1 ergibt sich φ = 45°+ Θ.

Das Verhältnis $\dfrac{U_{p-1}}{U_{p-1} - U_p}$ in Gleichung (2) lässt sich auf einfache Weise mittels eines A/D-Wandlers bestimmen, indem der Wert des Zählers, also $U_{p-1}$, dem Signaleingang und der Wert des Nenners, also $V_{p-1} - U_p$, dem Referenzeingang des A/D-Wandlers zugeführt werden. Die Zahl am Ausgang des A/D-Wandlers ist dann gleich dem Verhältnis $\dfrac{U_{p-1}}{U_{p-1} - U_p}$. Wenn die Anzahl n der Magnetfeldsensoren eine ganzzahlige Potenz der Zahl 2 ist, dann kann der Winkel φ durch eine binäre Zahl dargestellt werden, deren "most significant bits" die Zahl (p-1) und deren "least significant bits" die vom A/D-Wandler gelieferte Zahl darstellen. Bei einer Anzahl von n = 8 Magnetfeldsensoren lässt sich bereits mit einem 6-Bit A/D-Wandler eine dem durch die Verwendung der Näherungsformel gegebenen maximalen Fehler angepasste Genauigkeit erzielen. Zu beachten ist, dass in den angegebenen Gleichungen die Indizes, die jeweils einen bestimmten Magnetfeldsensor bezeichnen, immer modulo der Anzahl n der Magnetfeldsensoren einzusetzen sind.

Das Verhältnis $\dfrac{U_{p-1}}{U_{p-1} - U_p}$ kann auch mit einer analogen Schaltung gebildet werden. Aus der Gleichung

$$\frac{U_{p-1}}{U_{p-1} - U_p} = \frac{u}{r}, \tag{5}$$

wobei die Zahl u die gesuchte digitale Zahl ist, die das Verhältnis $\dfrac{U_{p-1}}{U_{p-1} - U_p}$ in Einheiten einer festen Zahl r angibt, erhält man durch Umformen die Gleichungen

$$(r-u)*U_{p-1} + u*U_p = 0, \text{ bzw.} \tag{6}$$

$$(r-u)*I_{p-1} + u*I_p = 0, \tag{7}$$

wobei $I_{p-1}$ und $I_p$ den Ausgangssignalen $U_{p-1}$ und $U_p$ proportionale Ströme sind. Die Gleichung (7) kann mittels einer analogen Schaltung, die einen Kondensator und einen Komparator umfasst, gelöst und in eine digitale Zahl gewandelt werden. Die Ströme $I_{p-1}$ und $I_p$ laden und entladen den Kondensator gemäss dem folgenden Verfahren:

1) Der Kondensator wird während einer vorbestimmten Dauer $\Delta t$ mit dem Strom $I_{p-1}$ geladen.

2) Es folgen nun r-1 Zyklen, in denen der Kondensator während der Dauer $\Delta t$ mit dem Strom $I_{p-1}$ geladen wird, wenn die Spannung am Kondensator zu Beginn des Zyklus negativ war, und in denen der Kondensator während der Dauer $\Delta t$ mit dem Strom $I_p$ entladen wird, wenn die Spannung am Kondensator am Beginn des Zyklus positiv war. Zur Feststellung des Vorzeichens der Spannung am Kondensator zu Beginn des Zyklus dient der Komparator.

Bei der Durchführung dieser r Zyklen nähert sich die Spannung am Kondensator immer mehr der Spannung U=0 an. Die Zahl der Entladezyklen ist gleich der Zahl u, die Zahl der Ladezyklen ist gleich der Zahl (r-u).

3) Der Winkel $\theta$ in Einheiten von $\dfrac{360°}{n*r}$ ist dann gegeben durch die Anzahl u der Entladezyklen, in denen der Kondensator mit dem Strom $I_{p-1}$ entladen worden war.

Die Anzahl r der Lade- und Entladezyklen des Kondensators sowie die Anzahl n der Magnetfeldsensoren bestimmen die Auflösung. Wenn die Auflösung beispielsweise 0.5° betragen soll, dann müssen r = 2*360/n Lade- und Entladezyklen durchgeführt werden.

Der mit dem erfindungsgemässen Verfahren ermittelte Winkel $\theta$ ist infolge der Näherung tan(x) = x mit einem systematischen Fehler behaftet. Dieser systematische Fehler kann mit einer Kennlinie eliminiert werden. Dazu ist beispielsweise eine Tabelle zusätzlich auf dem Halbleiterchip 2 integriert, beispielsweise als ROM (read only memory), wo der ermittelten Zahl u eine Zahl v zugeordnet ist. Die Zahl v entspricht dem korrekten Wert. Es ist deshalb vorteilhaft, nach dem Schritt b) das ermittelte Verhältnis $\dfrac{U_{p-1}}{U_{p-1} - U_p}$ bzw. die mit dem A/D-Wandler ermittelte Zahl bzw. die gemäss dem vorstehend erläuterten Verfahren ermittelte Zahl u mittels der Kennlinie zu korrigieren und so den um den systematischen Fehler bereinigten Winkel $\theta$ mit grösserer Genauigkeit zu erhalten.

Dieses Ausführungsbeispiel weist mehrere Vorzüge auf. Ein Vorzug besteht darin, dass der Magnetfeldkonzentrator das zu messende Magnetfeld verstärkt. Ein zweiter Vorzug ergibt sich daraus, dass pro Messachse zwei Magnetfeldsensoren vorhanden sind, deren Ausgangssignale unterschiedliche Vorzeichen haben. Der Vorzug liegt darin, dass es bei der Bestimmung des Winkels $\varphi$ keine Rolle spielt, ob das Magnetfeld in die positive oder negative Richtung der Messachse zeigt. Wenn der Winkel $\varphi$ wie im dargestellten Beispiel 60° beträgt, dann werden für die Bestimmung des Winkels $\varphi$ die beiden benachbarten Magnetfeldsensoren 3.1 und 3.2 verwendet. Wenn der Winkel $\varphi$ jedoch 60° + 180° = 240° beträgt, dann werden für die Bestimmung des Winkels $\varphi$ die beiden benachbarten Magnetfeldsensoren 3.5 und 3.6 verwendet. Der Winkel $\varphi$ könnte zwar aus den Ausgangssignalen der beiden Magnetfeldsensoren 3.1 und 3.2 berechnet werden, allerdings müssten in diesem Fall ihre Vorzeichen vertauscht und 180° zum berechneten Winkel $\varphi$ addiert werden. Dies ist aufwendiger und komplizierter.

Im folgenden werden weitere Varianten dieses Ausführungsbeispiels erläutert.

Variante 2

Die Lage der Nulldurchgangslinie 10 ergibt sich aus der Richtung des externen Magnetfeldes. Die Bestimmung der beiden benachbarten Magnetfeldsensoren im Schritt a, zwischen denen das Vorzeichen der Ausgangssignale von einem positiven Wert auf einen negativen Wert wechselt, kann deshalb auch erfolgen, indem zunächst die beiden benachbarten Magnetfeldsensoren ennittelt werden, deren Ausgangssignal die beiden grössten Werte aufweisen. Im Beispiel der Fig. 1 sind das die beiden Magnetfeldsensoren 3.1 und 3.2. Wenn deren Ausgangsspannungen mit $U_k$ und $U_{k+1}$ bezeichnet werden, dann tragen die beiden benachbarten Magnetfeldsensoren, zwischen denen das Vorzeichen der Ausgangssignale wechselt, die Nummern k+n/4 und k+1+n/4.

### Variante 2

Bei Anwendungen, bei denen die Richtung des externen Magnetfeldes nicht sprunghaft ändert, kann der Schritt a bei nachfolgenden Messungen weggelassen werden, solange die Vorzeichen der beiden Ausgangssignale $U_{p-1}$ und Up nicht ändern.

### Variante 3

Die Bestimmung der Richtung des externen Magnetfeldes in der vom Magnetfeldkonzentrator 1 aufgespannten xy-Ebene ist auch möglich, wenn die Hälfte der Magnetfeldsensoren, nämlich die Magnetfeldsensoren mit den Nummern $\frac{n}{2}, \frac{n}{2}+1, ..., n$ weggelassen werden. Der Grund liegt darin, dass beim Ausführungsbeispiel gemäss der Fig. 1 pro Messachse zwei Magnetfeldsensoren vorhanden sind, die die gleiche Information liefern. Die einfachste Möglichkeit, den Winkel $\varphi$ zu bestimmen, ist, die weggelassenen Magnetfeldsensoren wieder als fiktive Magnetfeldsensoren einzuführen, wobei das Ausgangssignal $U_{n/2+r}$ des fiktiven Magnetfeldsensors mit der Nummer n/2+r gleich dem Ausgangssignal des Magnetfeldsensors mit der Nummer r, aber mit umgekehrtem Vorzeichen gesetzt wird: $U_{n/2+r} = - U_r$. Ein fiktiver Magnetfeldsensor ist also ein Magnetfeldsensor, der physisch nicht vorhanden ist, dem aber ein polarer Winkel und ein Ausgangssignal zugeordnet werden, die bei der Auswertung gebraucht werden. Die Auswertung kann dann wie beim ersten Ausführungsbeispiel erfolgen. Diese Lösung erspart es, den Betrag und das Vorzeichen der Ausgangssignale zu analysieren und dann zu bestimmen, welche Ausgangssignale und ob mit oder ohne umgekehrtem Vorzeichen für die Auswertung zu verwenden sind.

Die bisher beschriebenen Ausführungsbeispiele eignen sich für Anwendungen, bei denen eine allfällige z-Komponente des externen Magnetfeldes unbedeutend ist oder bei denen Magnetfeldsensoren verwendet werden, die empfindlich sind auf ein in der xy-Ebene verlaufendes Magnetfeld.

### Variante 4

Diese in der Fig. 3 dargestellte Variante ist von der vorhergehenden Variante 3 abgeleitet. Die Fig. 3 zeigt den Sensor wiederum in Aufsicht. Der Sensor enthält eine Anzahl von k Magnetfeldsensoren, die empfindlich sind auf ein Magnetfeld, das parallel zur Oberfläche des Halbleiterchips 2 verläuft. Die Magnetfeldsensoren sind beispielsweise vertikale Hallelemente, deren Orientierung verschieden ist. Der Sensor enthält keinen Magnetfeldkonzentrator. Weil kein Magnetfeldkonzentrator vorhanden ist, können die Magnetfeldsensoren an einem beliebigen Ort auf dem Halbleiterchip 2 angeordnet sein. Die k Magnetfeldsensoren sind wie vorhin nummeriert, aber je anders orientiert, nämlich so, dass das Ausgangssignal des Magnetfeldsensors mit der Nummer m dann maximal ist, wenn das Magnetfeld in die durch den Winkel $\Psi_m = m \frac{360°}{2k}$ definierte Richtung zeigt. Für k = 4 ergeben sich die Winkel $\psi_0 = 0°$, $\psi_1 = 45°$, $\psi_2 = 90°$ und $\psi_3 = 135°$. In der Fig. 3 sind zur Verdeutlichung der Orientierung der vier Magnetfeldsensoren 3.0 bis 3.3 Hilfslinien und die Winkel $\psi_0$, $\psi_1$, $\psi_2$ und $\psi_3$ eingetragen. Ob zwei Magnetfeldsensoren "benachbarte" Magnetfeldsensoren sind, ergibt sich nicht auf Grund ihres Ortes auf dem Halbleiterchip 2, sondern auf Grund ihrer durch den Winkel $\psi_m$ definierten Orientierung. Da nun festgelegt ist, welche Magnetfeldsensoren als "benachbart" gelten, kann die Bestimmung der Richtung des Magnetfeldes in der durch die Oberfläche des Halbleiterchips 2 definierten Ebene gemäss dem vorstehend beschriebenen Verfahren erfolgen. Die Magnetfeldsensoren können also dicht nebeneinander platziert werden. Angemerkt wird noch, dass die Richtung des durch die vertikalen Hallelemente fliessenden Stromes bei allen vertikalen Hallelementen die gleiche ist, da eine Umkehrung der Stromrichtung einer Winkeländerung von $\psi_m$ nach $\psi_m$ + 180° entspricht. Die Stromrichtung ist in den vier Magnetfeldsensoren durch einen Pfeil dargestellt. Ein solcher Magnetfeldsensor kann beispielsweise in einem Winkelgeber verwendet werden, wo der Magnetfeldsensor relativ zu einem Magneten um eine Achse dreht. In diesem Fall ist es sinnvoll, die vertikalen Hallelemente symmetrisch zu einer senkrecht zur Oberfläche des Halbleiterchips verlaufenden Achse auszurichten, die im eingebauten Zustand im Winkelgeber mit der Rotationsachse des Winkelgebers zusammenfällt.

Wenn zusätzlich wieder wie bei der vorhergehenden Variante 4 n/2 fiktive Magnetfeldsensoren eingeführt und deren Ausgangssignale gebildet werden, dann kann die Ausweitung wie beim ersten Ausführungsbeispiel erfolgen.

Variante 5

Diese bevorzugte Variante eignet sich für Anwendungen, bei denen die z-Komponente des externen Magnetfeldes einen unerwünschten Beitrag zu den Ausgangssignalen der Magnetfeldsensoren liefert. Die Anzahl n der Magnetfeldsensoren ist eine gerade Zahl, so dass je zwei Magnetfeldsensoren bezüglich des Ursprungs 5 des polaren Koordinatensystems einander paarweise gegenüberliegen. Die z-Komponente des externen Magnetfeldes liefert bei einander gegenüberliegenden Magnetfeldsensoren eines Paars den gleichen Beitrag zu den Ausgangssignalen, während die xy-Komponenten des externen Magnetfeldes betragsmässig gleiche Beiträge, jedoch mit unterschiedlichem Vorzeichen zu den Ausgangssignalen liefern. Die Ausgangssignale der beiden Magnetfeldsensoren eines Paars werden daher voneinander subtrahiert, d.h. für die Berechnung des Winkels θ wird anstelle der Gleichung (2) die Gleichung

$$\Theta = \frac{360°}{n} \frac{U_{p-1} - U_{p-1+\frac{n}{2}}}{\left(U_{p-1} - U_{p-1+\frac{n}{2}}\right) - \left(U_p - U_{p+\frac{n}{2}}\right)} \ , \tag{8}$$

verwendet, wobei die Werte $p - 1 + \dfrac{n}{2}$ und $p + \dfrac{n}{2}$ jeweils modulo n zu nehmen sind. Im Beispiel der Fig. 1 erhält man

$$\Theta = 45° \frac{U_3 - U_7}{\left(U_3 - U_7\right) - \left(U_4 - U_0\right)} \ , \tag{9}$$

da 8 modulo 8 = 0 ist.

Der erfindungsgemässe Sensor bietet den Vorteil, dass die Bestimmung der Richtung des Magnetfeldes in der durch den Magnetfeldkonzentrator 1 aufgespannten xy-Ebene ohne aufwendige Rechenoperationen möglich ist. In einem weiteren nicht erfindungsgemäßem Beispiel lässt sich der Sensor zudem erweitern für den Betrieb in zwei verschiedenen Betriebsmodi. Im ersten Betriebsmodus wird die Richtung des externen Magnetfeldes gemäss dem vorhin beschriebenen Verfahren bestimmt, wenn das grösste der Ausgangssignale $U_0$ bis $U_{n-1}$ einen vorbestimmten Wert $U_{lim}$ überschreitet. Wenn das grösste der Ausgangssignale $U_0$ bis $U_{n-1}$ den vorbestimmten Wert $U_{lim}$ unterschreitet, dann arbeitet der Sensor in einem zweiten Betriebsmodus, in dem die Richtung des externen Magnetfeldes auf analoge Weise anhand der Ausgangssignale der beiden benachbarten Magnetfeldsensoren bestimmt wird, deren Ausgangssignale am grössten sind.

**Patentansprüche**

1. Sensor für die Detektion der Richtung eines Magnetfeldes in einer Ebene, wobei die Richtung des Magnetfeldes durch die Angabe eines polaren Winkels φ definierbar ist, wobei der Sensor eine Anzahl n von Magnetfeldsensoren (3.0 bis 3.7) aufweist, und wobei der Sensor Logik- und Auswerteschaltungen aufweist, **dadurch gekennzeichnet, dass** jedem Magnetfeldsensor eine Messachse (8.1 bis 8.4) derart zugeordnet ist, dass der Absolutbetrag des Ausgangssignals des Magnetfeldsensors dann am grössten ist, wenn das Magnetfeld parallel zu der zugeordneten Messachse verläuft, dass die Anzahl k der Messachsen wenigstens drei beträgt und dass die Logik- und Auswerteschaltungen eingerichtet sind, die Richtung des Magnetfeldes in der Ebene mit folgenden Schritten zu bestimmen:

   Auswählen von zwei Magnetfeldsensoren, die zu verschiedenen Messachsen gehören und deren Ausgangssignale betragsmässig kleiner als die Ausgangssignale der Magnetfeldsensoren sind, die zu anderen Messachsen gehören, und
   Bestimmen des Winkels φ aus den Ausgangssignalen der beiden ausgewählten Magnetfeldsensoren.

2. Sensor nach Anspruch 1, **dadurch gekennzeichnet, dass** je zwei Magnetfeldsensoren paarweise zu einer Messachse gehören, wobei die Vorzeichen der Ausgangssignale der beiden Magnetfeldsensoren eines Paares verschieden sind, dass jedem Magnetfeldsensor eine Nummer m und ein polarer Winkel $\Psi_m = m\dfrac{180°}{n}$ zugeordnet sind, wobei der Index m eine von 0 bis n-1 laufende Zahl ist, und dass die Logik- und Auswerteschaltungen eingerichtet sind, den Winkel φ gemäss den folgenden Schritten zu bestimmen:

a) Ermitteln eines Winkels $\theta$ aus den Ausgangssignalen der beiden ausgewählten Magnetfeldsensoren, deren Indizes mit p-1 und p bezeichnet werden; und

b) Berechnen des Winkels ($\varphi$ zu $\varphi = \psi_{p-1} + \theta$.

**3.** Sensor nach Anspruch 2, **dadurch gekennzeichnet, dass** die Ermittlung des Winkels $\theta$ die Ermittlung des Verhältnisses $\dfrac{U_{p-1}}{U_{p-1} - U_p}$ einschliesst, wobei $U_{p-1}$ und Up die Ausgangssignale der ausgewählten Magnetfeldsensoren bezeichnen.

**4.** Sensor nach Anspruch 2, **dadurch gekennzeichnet, dass** die Ermittlung des Winkels $\theta$ die Ermittlung des Verhältnisses $\dfrac{U_{p-1} - U_{p-1+\frac{n}{2}}}{\left( U_{p-1} - U_{p-1+\frac{n}{2}} \right) - \left( U_p - U_{p+\frac{n}{2}} \right)}$ einschliesst, wobei die Indizes modulo n zu setzen sind und wobei $U_{p-1}$, $U_p$, $U_{p-1+n/2}$ und $U_{p+n/2}$ die Ausgangssignale der ausgewählten Magnetfeldsensoren bezeichnen.

**5.** Sensor nach einem der Ansprüche 2 bis 4, **dadurch gekennzeichnet, dass** der im Schritt a) aus den Ausgangssignalen der ausgewählten Magnetfeldsensoren ermittelte Winkel $\theta$ mittels einer Kennlinie korrigiert wird.

**6.** Sensor nach Anspruch 3 oder **4, dadurch gekennzeichnet, dass** die Ermittlung von $\dfrac{U_{p-1}}{U_{p-1} - U_p}$ bzw. $\dfrac{U_{p-1} - U_{p-1+\frac{n}{2}}}{\left( U_{p-1} - U_{p-1+\frac{n}{2}} \right) - \left( U_p - U_{p+\frac{n}{2}} \right)}$ mittels eines A/D-Wandlers erfolgt, wobei der Wert des Zählers einem Signaleingang des A/D-Wandlers und der Wert des Nenners einem Referenzeingang des A/D-Wandlers zugeführt wird.

**7.** Sensor nach Anspruch 3 oder 4, **dadurch gekennzeichnet, dass** die Ermittlung von $\dfrac{U_{p-1}}{U_{p-1} - U_p}$ bzw. $\dfrac{U_{p-1} - U_{p-1+\frac{n}{2}}}{\left( U_{p-1} - U_{p-1+\frac{n}{2}} \right) - \left( U_p - U_{p+\frac{n}{2}} \right)}$ erfolgt, indem ein Kondensator in einer vorbestimmten Anzahl von Zyklen von einer vorbestimmten Zeitdauer mit einem dem Ausgangssignal $U_p$ bzw. $U_p - U_{p+\frac{n}{2}}$ proportionalen Strom $I_1$ geladen oder mit einem dem Ausgangssignal $U_{p-1}$ bzw. $U_{p-1} - U_{p-1+\frac{n}{2}}$ proportionalen Strom $I_2$ entladen wird, wobei das Vorzeichen der Spannung am Kondensator angibt, ob der Kondensator im nächsten Zyklus mit dem Strom $I_1$ geladen oder dem Strom $I_2$ entladen wird.

**8.** Verfahren zur Bestimmung der Richtung eines Magnetfeldes in einer Ebene mit einem Sensor, wobei der Sensor eine Anzahl n von Magnetfeldsensoren (3.0 bis 3.7) aufweist, wobei jedem Magnetfeldsensor eine Messachse (8.1 bis 8.4) derart zugeordnet ist, dass der Absolutbetrag des Ausgangssignals des Magnetfeldsensors dann am grössten ist, wenn das Magnetfeld parallel zu der zugeordneten Messachse verläuft, wobei die Anzahl k der Messachsen wenigstens drei beträgt, und wobei die Richtung des Magnetfeldes in der Ebene durch einen polaren Winkel $\varphi$ definiert ist, **gekennzeichnet durch** folgende Schritte:

Auswählen von zwei Magnetfeldsensoren, die zu verschiedenen Messachsen gehören und deren Ausgangssignale betragsmässig kleiner als die Ausgangssignale der Magnetfeldsensoren sind, die zu den anderen Messachsen gehören, und

Bestimmen des Winkels $\varphi$ aus den Ausgangssignalen der beiden ausgewählten Magnetfeldsensoren.

9. Verfahren nach Anspruch 8, **dadurch gekennzeichnet, dass** je zwei Magnetfeldsensoren paarweise zu einer Messachse gehören, wobei die Vorzeichen der Ausgangssignale der beiden Magnetfeldsensoren eines Paares verschieden sind, dass jedem Magnetfeldsensor eine Nummer m und ein polarer Winkel $\Psi_m = m\dfrac{180°}{n}$ zugeordnet sind, wobei der Index m eine von 0 bis n-1 laufende Zahl ist, und dass der Winkel φ bestimmt wird gemäss den folgenden Schritten:

a) Ermitteln eines Winkels θ aus den Ausgangssignalen der beiden ausgewählten Magnetfeldsensoren, deren Indizes mit p-1 und p bezeichnet werden; und
b) Berechnen des Winkels φ zu φ = $\psi_{p-1}$ + θ.

10. Verfahren nach Anspruch 9, **dadurch gekennzeichnet, dass** die Ermittlung des Winkels θ die Ermittlung des Verhältnisses $\dfrac{U_{p-1}}{U_{p-1} - U_p}$ einschliesst, wobei $U_{p-1}$ und $U_p$ die Ausgangssignale der ausgewählten Magnetfeldsensoren bezeichnen.

11. Verfahren nach Anspruch 9, **dadurch gekennzeichnet, dass** die Ermittlung des Winkels θ die Ermittlung des Verhältnisses $\dfrac{U_{p-1} - U_{p-1+\frac{n}{2}}}{\left(U_{p-1} - U_{p-1+\frac{n}{2}}\right) - \left(U_p - U_{p+\frac{n}{2}}\right)}$ einschliesst, wobei die Indizes modulo n zu setzen sind und wobei $U_{p-1}$, $U_p$, $U_{p-1+n/2}$ und $U_{p+n/2}$ die Ausgangssignale der ausgewählten Magnetfeldsensoren bezeichnen.

12. Verfahren nach einem der Ansprüche 9 bis 11, **dadurch gekennzeichnet, dass** der im Schritt a) aus den Ausgangssignalen der ausgewählten Magnetfeldsensoren ermittelte Winkel θ mittels einer Kennlinie korrigiert wird.

13. Verfahren nach Anspruch 10 oder 11, **dadurch gekennzeichnet, dass** die Ermittlung von $\dfrac{U_{p-1}}{U_{p-1} - U_p}$ bzw. $\dfrac{U_{p-1} - U_{p-1+\frac{n}{2}}}{\left(U_{p-1} - U_{p-1+\frac{n}{2}}\right) - \left(U_p - U_{p+\frac{n}{2}}\right)}$ mittels eines A/D-Wandlers erfolgt, wobei der Wert des Zählers einem Signaleingang des A/D-Wandlers und der Wert des Nenners einem Referenzeingang des A/D-Wandlers zugeführt wird.

14. Verfahren nach Anspruch 10 oder 11, **dadurch gekennzeichnet, dass** die Ermittlung von $\dfrac{U_{p-1}}{U_{p-1} - U_p}$ bzw. $\dfrac{U_{p-1} - U_{p-1+\frac{n}{2}}}{\left(U_{p-1} - U_{p-1+\frac{n}{2}}\right) - \left(U_p - U_{p+\frac{n}{2}}\right)}$ erfolgt, indem ein Kondensator in einer vorbestimmten Anzahl von Zyklen von einer vorbestimmten Zeitdauer mit einem dem Ausgangssignal $U_p$ bzw. $U_p - U_{p+\frac{n}{2}}$ proportionalen Strom $I_1$ geladen oder mit einem dem Ausgangssignal $U_{p-1}$ bzw. $U_{p-1} - U_{p-1+\frac{n}{2}}$ proportionalen Strom $I_2$ entladen wird, wobei das Vorzeichen der Spannung am Kondensator angibt, ob der Kondensator im nächsten Zyklus mit dem Strom $I_1$ geladen oder dem Strom $I_2$ entladen wird.

**Claims**

1. Sensor for detecting the direction of a magnetic field in a plane, wherein the direction of the magnetic field is definable by means of specifying a polar angle $\varphi$, wherein the sensor has a number of n magnetic field sensors (3.0 to 3.7), and wherein the sensor has logic and evaluation circuits, **characterised in that** a measuring axis (8.1 to 8.4) is assigned to each magnetic field sensor in such a way that the absolute value of the output signal of the magnetic field sensor achieves a maximum when the magnetic field runs parallel to the assigned measuring axis, that the number k of measuring axes amounts to at least three and that the logic and evaluation circuits are configured to determine the direction of the magnetic field in the plane with the following steps:

    selecting two magnetic field sensors that belong to different measuring axes and the output signals of which in terms of absolute value are smaller than the output signals of the magnetic field sensors that belong to other measuring axes, and determining the angle $\varphi$ from the output signals of the two selected magnetic field sensors.

2. Sensor according to claim 1, **characterised in that** two magnetic field sensors belong in pairs to a measuring axis, wherein the signs of the output signals of the two magnetic field sensors of a pair are different, that a number m and a polar angle $\Psi_m = m\dfrac{180°}{n}$ are assigned to each magnetic field sensor, n wherein the index m is a number running from 0 to n-1, and that the logic and evaluation circuits are configured to determine the angle $\varphi$ in accordance with the following steps:

    a) Determining an angle $\theta$ from the output signals of the two selected magnetic field sensors the indices of which are designated as p-1 and p; and
    b) Calculating the angle $\varphi$ to $\varphi = \psi_{p-1} + \theta$.

3. Sensor according to claim 2, **characterised in that** the determination of the angle $\theta$ includes the determination of the ratio $\dfrac{U_{p-1}}{U_{p-1} - U_p}$, wherein $U_{p-1}$ and Up designate the output signals of the selected magnetic field sensors.

4. Sensor according to claim 2, **characterised in that** the determination of the angle $\theta$ includes the determination of the ratio $\dfrac{U_{p-1} - U_{p-1+\frac{n}{2}}}{\left(U_{p-1} - U_{p-1+\frac{n}{2}}\right) - \left(U_p - U_{p+\frac{n}{2}}\right)}$, wherein the indices are to be set modulo n and wherein $U_{p-1}$, $U_p$, $U_{p-1+n/2}$ and $U_{p+n/2}$ designate the output signals of the selected magnetic field sensors.

5. Sensor according to any of claims 2 to 4, **characterised in that** the angle $\theta$ determined in step a) from the output signals of the selected magnetic field sensors is corrected by means of a characteristic curve.

6. Sensor according to claim 3 or 4, **characterised in that** the determination of $\dfrac{U_{p-1}}{U_{p-1} - U_p}$ or $\dfrac{U_{p-1} - U_{p-1+\frac{n}{2}}}{\left(U_{p-1} - U_{p-1+\frac{n}{2}}\right) - \left(U_p - U_{p+\frac{n}{2}}\right)}$, respectively, is done by means of an A/D converter, wherein the value of the numerator is fed to a signal input of the A/D converter and the value of the denominator to a reference input of the A/D converter.

7. Sensor according to claim 3 or 4, **characterised in that** the determination of $\dfrac{U_{p-1}}{U_{p-1} - U_p}$ or

$$\frac{U_{p-1} - U_{p-1+\frac{n}{2}}}{\left(U_{p-1} - U_{p-1+\frac{n}{2}}\right) - \left(U_p - U_{p+\frac{n}{2}}\right)},$$ respectively, occurs **in that** in a predetermined number of cycles of a predetermined duration a capacitor is loaded with a current $I_1$ proportional to the output signal $U_p$ or $U_{p-1} - U_{p-1+\frac{n}{2}}$ ,respectively, or is unloaded with a current $I_2$ proportional to the output signal $U_{p-1}$ or $U_p - U_{p+\frac{n}{2}}$ , respectively, wherein the sign of the voltage at the capacitor indicates whether in the next cycle the capacitor is loaded with the current $I_1$ or unloaded with the current $I_2$.

8. Method for detecting a direction of a magnetic field in a plane with a sensor, wherein the sensor comprises a number n of magnetic field sensors (3.0 to 3.7), wherein a measuring axis (8.1 to 8.4) is assigned to each magnetic field sensor in such a way that an absolute value of an output signal of the magnetic field sensor achieves a maximum when the magnetic field runs parallel to the measuring axis, and wherein the number k of measuring axes amounts to at least three, and wherein the direction of the magnetic field in the plane is defined by an angle $\varphi$, **characterized by** the following steps:

> selecting two magnetic field sensors that belong to different measuring axes and the absolute values of the output signals of which are smaller than the absolute values of the output signals of the magnetic field sensors that belong to the other measuring axes; and
> determining the angle $\varphi$ from the output signals of the two selected magnetic field sensors.

9. Method according to claim 8, **characterized in that** two magnetic field sensors belong in pairs to a measuring axis, wherein the signs of the output signals of the two magnetic field sensors of a pair are different, wherein an index m and an angle $\Psi_m = m\dfrac{180°}{n}$ are assigned to each magnetic field sensor, the index m is a number running from 0 to n-1, and that the angle $\varphi$ is determined with the following steps:

> a) determining an angle $\theta$ from the output signals of the two selected magnetic field sensors, the indices of which are denoted as p-1 and p; and
> b) calculating the angle $\varphi$ to $\varphi = \psi_{p-1} + \theta$.

10. Method according to claim 9, **characterized in that** the determination of the angle $\theta$ includes the determination of the ratio $\dfrac{U_{p-1}}{U_{p-1} - U_p}$ , wherein $U_{p-1}$ and $U_p$ designate the output signals of the selected magnetic field sensors.

11. Method according to claim 9, **characterized in that** the determination of the angle $\theta$ includes the determination of the ratio $\dfrac{U_{p-1} - U_{p-1+\frac{n}{2}}}{\left(U_{p-1} - U_{p-1+\frac{n}{2}}\right) - \left(U_p - U_{p+\frac{n}{2}}\right)}$ ,wherein the indices are to be set modulo n and wherein $U_{p-1}$, $U_p$, $U_{p-1+n/2}$ and $U_{p+n/2}$ designate the output signals of the selected magnetic field sensors.

12. Method according to any of claims 9 to 11, **characterized in that** the angle $\theta$ determined in step a) from the output signals of the selected magnetic field sensors is corrected by means of a characteristic curve.

13. Method according to claim 10 or 11, **characterized in that** the determination of the ratio $\dfrac{U_{p-1}}{U_{p-1} - U_p}$ or

$$\frac{U_{p-1} - U_{p-1+\frac{n}{2}}}{\left(U_{p-1} - U_{p-1+\frac{n}{2}}\right) - \left(U_p - U_{p+\frac{n}{2}}\right)},[1]$$ respectively, occurs by means of an A/D converter, wherein the value of the numerator is fed to a signal input of the A/D converter and the value of the denominator to a reference input of the A/D converter.

**14.** Method according to claim 10 or 11, **characterized in that** the determination of the ratio $\dfrac{U_{p-1}}{U_{p-1} - U_p}$ or

$$\frac{U_{p-1} - U_{p-1+\frac{n}{2}}}{\left(U_{p-1} - U_{p-1+\frac{n}{2}}\right) - \left(U_p - U_{p+\frac{n}{2}}\right)},$$ respectively, occurs **in that** in a predetermined number of cycles of a predetermined duration a capacitor is loaded with a current $I_1$ proportional to the output signal Up or $U_{p-1} - U_{p-1+\frac{n}{2}}$ ,respectively, or is unloaded with a current $I_2$ proportional to the output signal $U_{p-1}$ or $U_p - U_{p+\frac{n}{2}}$ ,respectively, wherein the sign of the voltage at the capacitor indicates whether in the next cycle the capacitor is loaded with the current $I_1$ or unloaded with the current $I_2$.

## Revendications

**1.** Capteur pour détecter la direction d'un champ magnétique dans un plan, dans lequel la direction du champ magnétique peut être défini au moyen de la spécification d'un angle polaire φ, dans lequel le capteur comporte un certain nombre de n capteurs de champ magnétique (3.0 à 3.7), et dans lequel le capteur comporte des circuits logiques et d'évaluation, **caractérisé en ce qu'** un axe (8.1 à 8.4) est attribué à chaque capteur de champ magnétique de telle sorte que la valeur absolue du signal de sortie du capteur de champ magnétique atteint un maximum lorsque le champ magnétique est parallèle à l'axe de mesure attribué, que le nombre k d'axes de mesure est d'au moins trois et en ce que les circuits logiques et d'évaluation sont configurés pour déterminer la direction du champ magnétique dans le plan avec les étapes suivantes:

la sélection de deux capteurs de champ magnétique appartenant à des axes de mesure différents et les signaux de sortie desquels en termes de valeur absolue sont plus petites que les signaux de sortie des capteurs de champ magnétique qui appartiennent à d'autres axes de mesure, et la détermination de l'angle φ à partir des signaux de sortie des deux capteurs de champ magnétique sélectionnés.

**2.** Capteur selon la revendication 1, **caractérisé en ce que** deux capteurs de champ magnétique appartiennent en paires à un axe de mesure, dans lequel les signes des signaux de sortie des deux capteurs de champ magnétique d'une paire sont différents, dans lequel un indice m et un angle $\Psi_m = m\dfrac{180°}{n}$ sont n affectés à chaque capteur de champ magnétique, l'indice m étant un nombre de 0 à n-1, et **en ce que** les circuits logiques et d'évaluation sont configurés pour déterminer l'angle φ par les étapes suivantes:

a) la détermination d'un angle θ à partir des signaux de sortie des deux capteurs de champ magnétique sélectionnés, dont les indices sont désignés comme p-1 et p; et
b) la calcul de l'angle φ à φ = $\psi_{p-1}$ + θ.

**3.** Capteur selon la revendication 2, **caractérisé en ce que** la détermination de l'angle θ inclut la détermination du rapport $\dfrac{U_{p-1}}{U_{p-1} - U_p}$ ,dans lequel $U_{p-1}$ and Up désignent les signaux de sortie des capteurs de champ magnétique sélectionnés.

**4.** Capteur selon la revendication 2, **caractérisé en ce que** la détermination de l'angle θ inclut la détermination du

rapport $\dfrac{U_{p-1} - U_{p-1+\frac{n}{2}}}{\left(U_{p-1} - U_{p-1+\frac{n}{2}}\right) - \left(U_p - U_{p+\frac{n}{2}}\right)}$, dans lequel les indices sont à mettre modulo n et dans lequel $U_{p-1}$,

$U_p$, $U_{p-1+n/2}$ and $U_{p+n/2}$ désignent les signaux de sortie des capteurs de champ magnétique sélectionnés.

**5.** Capteur selon l'une quelconque des revendications 2 à 4, **caractérisé en ce que** l'angle θ déterminé à l'étape a) à partir des signaux de sortie des capteurs de champ magnétique sélectionnés est corrigé au moyen d'une courbe caractéristique.

**6.** Capteur selon la revendication 3 ou 4, **caractérisé en ce que** la détermination de $\dfrac{U_{p-1}}{U_{p-1} - U_p}$ ou

$\dfrac{U_{p-1} - U_{p-1+\frac{n}{2}}}{\left(U_{p-1} - U_{p-1+\frac{n}{2}}\right) - \left(U_p - U_{p+\frac{n}{2}}\right)}$, respectivement, se fait au moyen d'un convertisseur A/N, dans lequel la valeur du numérateur est amenée à une entrée de signal du convertisseur A/N et la valeur du dénominateur à une entrée de référence du convertisseur A/N.

**7.** Capteur selon la revendication 3 ou 4, **caractérisé en ce que** la détermination de $\dfrac{U_{p-1}}{U_{p-1} - U_p}$ ou

$\dfrac{U_{p-1} - U_{p-1+\frac{n}{2}}}{\left(U_{p-1} - U_{p-1+\frac{n}{2}}\right) - \left(U_p - U_{p+\frac{n}{2}}\right)}$, respectivement, se produit **en ce que** dans un nombre prédéterminé de cycles d'une durée prédéterminée un condensateur est chargé avec un courant $I_1$ proportionnel au signal de sortie

$U_p$ ou $U_{p-1} - U_{p-1+\frac{n}{2}}$, respectivement, ou est déchargé avec un courant $I_2$ proportionnel au signal de sortie $U_{p-1}$

ou $U_p - U_{p+\frac{n}{2}}$, respectivement, dans lequel le signe de la tension aux bornes du condensateur indique si dans le cycle suivant le condensateur est chargé avec le courant $I_1$ ou déchargé avec le courant $I_2$.

**8.** Procédé pour détecter une direction d'un champ magnétique dans un plan avec un capteur, dans lequel le capteur comporte un nombre n de capteurs de champ magnétique (3.0 à 3.7), dans lequel un axe de mesure (8.1 to 8.4) est attribué à chaque capteur de champ magnétique de telle sorte qu'une valeur absolue d'un signal de sortie du capteur de champ magnétique atteint un maximum lorsque le champ magnétique est parallèle à l'axe de mesure et dans lequel le nombre k des axes de mesure est d'au moins trois, et dans lequel la direction du champ magnétique dans le plan est définie par un angle φ, **caractérisé par** les étapes suivantes:

la sélection de deux capteurs de champ magnétique appartenant à des axes de mesure différents et les valeurs absolues des signaux de sortie qui sont plus petites que les valeurs absolues des signaux de sortie des capteurs de champ magnétique qui appartiennent aux autres axes de mesure; et
la détermination de l'angle φ à partir des signaux de sortie des deux capteurs de champ magnétique sélectionnés.

**9.** Procédé selon la revendication 8, **caractérisé en ce que** deux capteurs de champ magnétique appartiennent en paires à un axe de mesure, dans lequel les signes des signaux de sortie des deux capteurs de champ magnétique d'une paire sont différents, dans lequel un indice m et un angle $\Psi_m = m\dfrac{180°}{n}$ sont n affectés à chaque capteur de champ magnétique, l'indice m étant un nombre de 0 à n-1, et **en ce que** l'angle φ est déterminé par les étapes suivantes:

a) la détermination d'un angle $\theta$ à partir des signaux de sortie des deux capteurs de champ magnétique sélectionnés, dont les indices sont désignés comme p-1 et p; et

b) la calculation de l'angle $\varphi$ à $\varphi = \psi_{p-1} + \theta$.

**10.** Procédé selon la revendication 9, **caractérisé en ce que** la détermination de l'angle $\theta$ inclut la détermination du rapport $\dfrac{U_{p-1}}{U_{p-1} - U_p}$, dans lequel $U_{p-1}$ and $U_p$ désignent les signaux de sortie des capteurs de champ magnétique sélectionnés.

**11.** Procédé selon la revendication 9, **caractérisé en ce que** la détermination de l'angle $\theta$ inclut la détermination du rapport $\dfrac{U_{p-1} - U_{p-1+\frac{n}{2}}}{\left(U_{p-1} - U_{p-1+\frac{n}{2}}\right) - \left(U_p - U_{p+\frac{n}{2}}\right)}$, dans lequel les indices sont à mettre modulo n et dans lequel $U_{p-1}$, $U_p$, $U_{p-1+n/2}$ and $U_{p+n/2}$ désignent les signaux de sortie des capteurs de champ magnétique sélectionnés.

**12.** Procédé selon l'une quelconque des revendications 9 à 11, **caractérisé en ce que** l'angle $\theta$ déterminé à l'étape a) à partir des signaux de sortie des capteurs de champ magnétique sélectionnés est corrigée au moyen d'une courbe caractéristique.

**13.** Procédé selon la revendication 10 ou 11, **caractérisé en ce que** la détermination de $\dfrac{U_{p-1}}{U_{p-1} - U_p}$ ou $\dfrac{U_{p-1} - U_{p-1+\frac{n}{2}}}{\left(U_{p-1} - U_{p-1+\frac{n}{2}}\right) - \left(U_p - U_{p+\frac{n}{2}}\right)}$, respectivement, se fait au moyen d'un convertisseur A/N, dans lequel la valeur du numérateur est amenée à une entrée de signal du convertisseur A/N et la valeur du dénominateur à une entrée de référence du convertisseur A/N.

**14.** Procédé selon la revendication 10 ou 11, **caractérisé en ce que** la détermination de $\dfrac{U_{p-1}}{U_{p-1} - U_p}$ ou $\dfrac{U_{p-1} - U_{p-1+\frac{n}{2}}}{\left(U_{p-1} - U_{p-1+\frac{n}{2}}\right) - \left(U_p - U_{p+\frac{n}{2}}\right)}$, respectivement, se produit **en ce que** dans un nombre prédéterminé de cycles d'une durée prédéterminée un condensateur est chargé avec un courant $I_1$ proportionnel au signal de sortie Up ou $U_{p-1} - U_{p-1+\frac{n}{2}}$, respectivement, ou est déchargé avec un courant $I_2$ proportionnel au signal de sortie $U_{p-1}$ ou $U_p - U_{p+\frac{n}{2}}$, respectivement, dans lequel le signe de la tension aux bornes du condensateur indique si dans le cycle suivant le condensateur est chargé avec le courant $I_1$ ou déchargé avec le courant $I_2$.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1182461 A

- EP 0350342 W